# EUROPEAN PATENT SPECIFICATION

(11) **EP 3 005 237 B1**
(45) Date of publication and mention of the grant of the patent: **28.12.2022**
(21) Application number: 14804913.3
(22) Date of filing: 23.05.2014
(51) Int. Cl.: G06V 10/44

(54) **AUTOMATIC DETECTION OF REGULAR PATTERNS OF FEATURES**
AUTOMATISCHE ERKENNUNG VON REGELMÄSSIGEN MUSTERN VON EIGENSCHAFTEN
DÉTECTION AUTOMATIQUE DE FORMES D'ÉLÉMENTS RÉGULIÈRES

(30) Priority: 31.05.2013 US 201313907034
(43) Date of publication of application: 13.04.2016
(73) Proprietor: Siemens Industry Software Inc., Plano, TX 75024-6612 (US)
(72) Inventor: MATTSON, Howard Charles Duncan, Cambridge Cambridgeshire CB24 9US (GB); KING, Douglas Joseph, Peterborough Cambridgeshire PE7 1PY (GB); STAPLES, Daniel C., Cape Elizabeth, Maine 04107 (US)
(74) Representative: Maier, Daniel Oliver
(86) International application number: PCT/US2014/039315
(87) International publication number: WO 2014/193750

(56) References cited:
- WO-A2-02/13137
- US-A- 4 969 201
- US-A1- 2004 070 800
- US-A1- 2007 196 017
- US-A1- 2008 219 565
- US-A1- 2009 220 142
- US-A1- 2013 058 574
- US-B1- 7 643 968
- SUBRAHMANYAM S ET AL: "An overview of automatic feature recognition techniques for computer-aided process planning", COMPUTERS IN INDUSTRY, ELSEVIER, AMSTERDAM, NL, vol. 26, no. 1, 1 April 1995 (1995-04-01), pages 1-21, XP004011614, ISSN: 0166-3615, DOI: 10.1016/0166-3615(95)80003-4

## Description

### TECHNICAL FIELD

The present disclosure is directed, in general, to computer-aided design, visualization, and manufacturing systems, product lifecycle management ("PLM") systems, and similar systems, that manage data for products and other items (collectively, "Product Data Management" systems or PDM systems).

### BACKGROUND OF THE DISCLOSURE

Computer-aided design systems ("CAD systems") enable users to design and visualize model objects. Improved systems are desirable. WO02/13137A2 discloses a polygon finder and pruned tree geometric match method to compare confer features from a polygon model against corner features from an input image to locate an object in the image that matches the polygon.

### SUMMARY OF THE DISCLOSURE

A first aspect of the present invention is provided in the method of claim 1.

A second aspect of the present invention is provided in the data processing system of claim 6.

Before undertaking the DETAILED DESCRIPTION below, it may be advantageous to set forth definitions of certain words or phrases used throughout this patent document: the terms "include" and "comprise," as well as derivatives thereof, mean inclusion without limitation; the term "or" is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, whether such a device is implemented in hardware, firmware, software or some combination of at least two of the same. It should be noted that the functionality associated with any particular controller may be centralized or distributed, whether locally or remotely. Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects, and in which:
Figure 1 illustrates a block diagram of a data processing system in which an embodiment can be implemented;
Figure 2 illustrates a flowchart of a process in accordance with disclosed embodiments;
Figure 3A illustrates a model that includes a plurality of 3D features two different basic feature types, in accordance with disclosed embodiments;
Figure 3B illustrates the projection of the assigned points of features into a plane, in accordance with disclosed embodiments;
Figure 4 illustrates an example of a set of 2D points corresponding to a geometric model that can be processed in accordance with disclosed embodiments;
Figures 5A-5D illustrate examples of pattern indicators in accordance with disclosed embodiment;
Figure 6 illustrates one technique for calculating the center for the circular indicator, in accordance with disclosed embodiments; and
Figures 7A-7J illustrate an example of the results and advantages of an iterative process as described herein.

### DETAILED DESCRIPTION

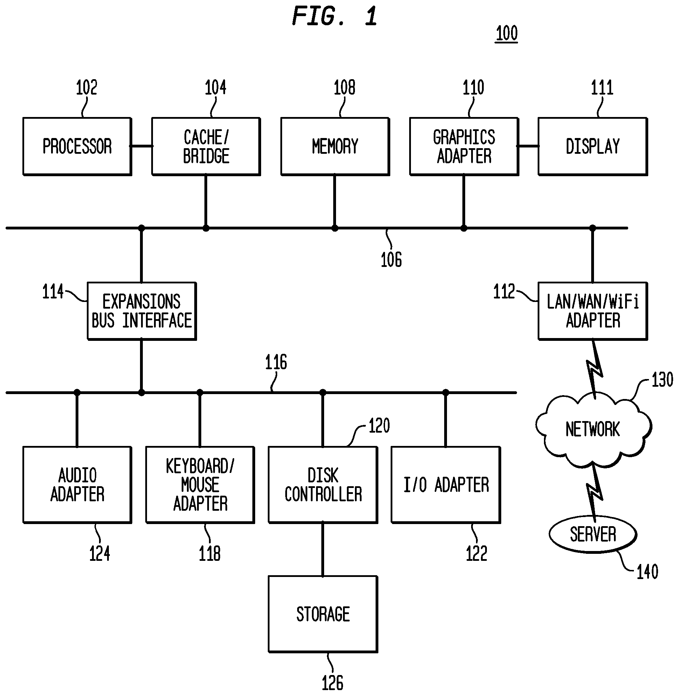

FIGURES 1 through 7J, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

CAD and other systems can maintain grids or patterns of features, which will be referred to generically as "patterns" herein. These patterns, as used herein refer to a structured organization of features of a geometric model with respect to each other. These features can be any elements of a geometric model maintained in a PDM or other system. Various systems include methods for patterns of features to be created and explicitly labeled and so function as part of the system.

However, many models may contain implicit patterns, not explicitly labeled, and which cannot, therefore, function properly in the system. These may arise in many ways including but not limited to data imported from a different system, features within models generated in earlier versions of the system, models created via un-conventional, indirect or obscure methods, and others.

Disclosed embodiments include systems and methods for automatically recognizing rectangular, circular, and linear patterns between features of geometric models.

Figure 1 illustrates a block diagram of a data processing system in which an embodiment can be implemented, for example as a CAD system particularly configured by software or otherwise to perform the processes as described herein, and in particular as each one of a plurality of interconnected and communicating systems as described herein. The data processing system depicted includes a processor 102 connected to a level two cache/bridge 104, which is connected in turn to a local system bus 106. Local system bus 106 may be, for example, a peripheral component interconnect (PCI) architecture bus. Also connected to local system bus in the depicted example are a main memory 108 and a graphics adapter 110. The graphics adapter 110 may be connected to display 111.

Other peripherals, such as local area network (LAN) / Wide Area Network / Wireless (e.g. WiFi) adapter 112, may also be connected to local system bus 106. Expansion bus interface 114 connects local system bus 106 to input/output (I/O) bus 116. I/O bus 116 is connected to keyboard/mouse adapter 118, disk controller 120, and I/O adapter 122. Disk controller 120 can be connected to a storage 126, which can be any suitable machine usable or machine readable storage medium, including but not limited to nonvolatile, hard-coded type mediums such as read only memories (ROMs) or erasable, electrically programmable read only memories (EEPROMs), magnetic tape storage, and user-recordable type mediums such as floppy disks, hard disk drives and compact disk read only memories (CD-ROMs) or digital versatile disks (DVDs), and other known optical, electrical, or magnetic storage devices.

Also connected to I/O bus 116 in the example shown is audio adapter 124, to which speakers (not shown) may be connected for playing sounds. Keyboard/mouse adapter 118 provides a connection for a pointing device (not shown), such as a mouse, trackball, trackpointer, touchpad, etc.

Those of ordinary skill in the art will appreciate that the hardware depicted in Figure 1 may vary for particular implementations. For example, other peripheral devices, such as an optical disk drive and the like, also may be used in addition or in place of the hardware depicted. The depicted example is provided for the purpose of explanation only and is not meant to imply architectural limitations with respect to the present disclosure.

A data processing system in accordance with an embodiment of the present disclosure includes an operating system employing a graphical user interface. The operating system permits multiple display windows to be presented in the graphical user interface simultaneously, with each display window providing an interface to a different application or to a different instance of the same application. A cursor in the graphical user interface may be manipulated by a user through the pointing device. The position of the cursor may be changed and/or an event, such as clicking a mouse button, generated to actuate a desired response.

One of various commercial operating systems, such as a version of Microsoft Windows^{™}, a product of Microsoft Corporation located in Redmond, Wash. may be employed if suitably modified. The operating system is modified or created in accordance with the present disclosure as described.

LAN/ WAN/Wireless adapter 112 can be connected to a network 130 (not a part of data processing system 100), which can be any public or private data processing system network or combination of networks, as known to those of skill in the art, including the Internet. Data processing system 100 can communicate over network 130 with server system 140, which is also not part of data processing system 100, but can be implemented, for example, as a separate data processing system 100.

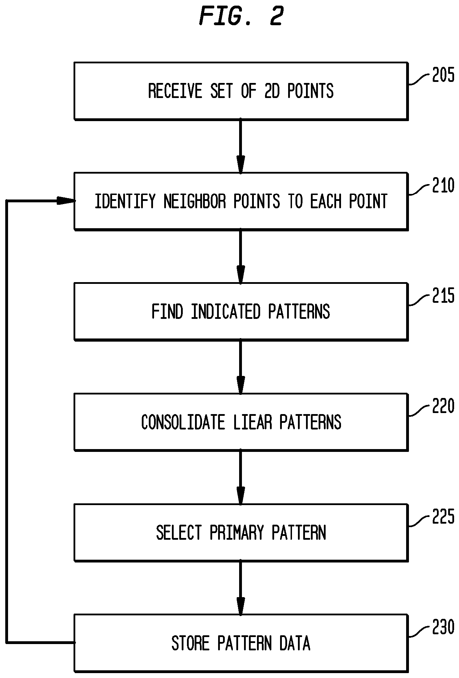

Disclosed embodiments can analyze a geometric model including a plurality of features and automatically recognize patterns between the features. Figure 2 illustrates a flowchart of a process in accordance with disclosed embodiments that may be performed, for example, by one or more CAD systems (referred to generically below as the "system"); other figures are used in the description below to illustrate aspects or examples of such a process.

The system receives a set of two-dimensional 2D points representing at least a portion of a geometric model (205). Receiving, as used herein, can include loading from storage, receiving from another device or process, receiving via an interaction with a user, preprocessing other data to produce the received data, or otherwise.

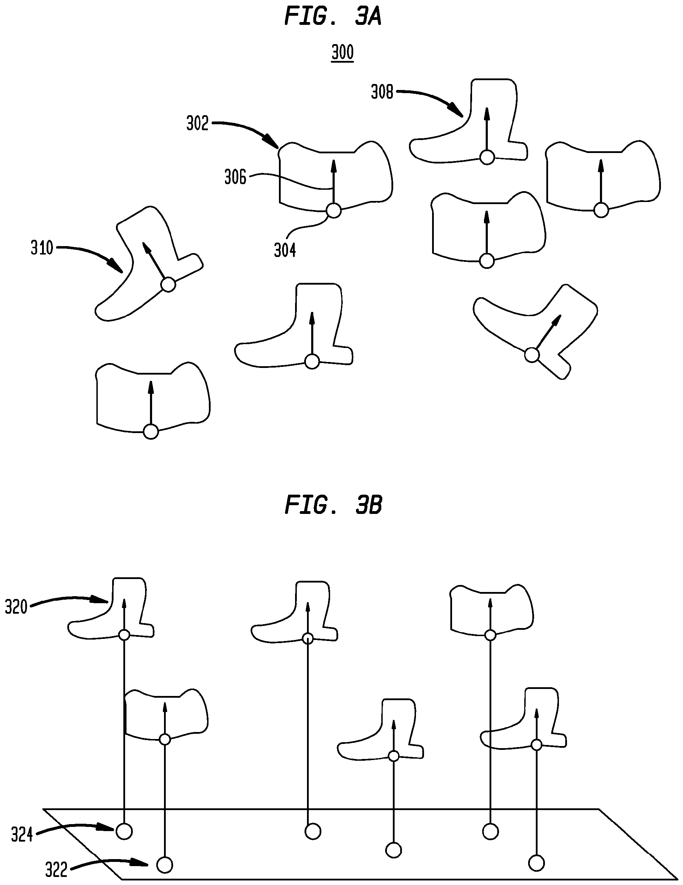

A process in accordance with disclosed embodiments can take as input a simple set of 2D points. The raw input from a model can alternately be either 2D or three-dimensional (3D) features, and as part of 205, the system can obtain a consistent representative point for each of the features, as described in more detail below with reference to Figs. 3A and 3B.

Figure 3A illustrates a model 300 that includes a plurality of 3D features of two different basic feature types (shapes). For each of the feature types, the system can assign a consistent point on the feature type and an orientation vector for the feature. For example, feature 302 is a specific feature type with a specific shape; the system assigns a point 304 at the same location on each of these shapes, and assigns an orientation vector 306, originating at the point 304, that indicates the orientation of each shape. The original assignment of the point and vector on the first one of any given feature type can be arbitrary, and the remaining assignments for identical feature types are assigned relative to the first one of that type.

For features whose points are not already in 2D space, the system can convert the points into 2D space by projecting onto a common plane. Figure 3B illustrates the projection of the assigned points of features 320 into a plane 322. Projected points 324 correspond to the location of the points on each of the features 320.

Features in the model will likely have many different types, shapes, sizes, orientations and, in 3D, heights from plane. Any, some, or all of these variables, plus others, can be used to pre-divide the input.

For example, if features of different types should not be considered for inclusion into a pattern, then they can be divided out and can be passed to separate and distinct calls to the detection process. That is, where only patterns among common feature types should be identified, then the detection processes described herein can be separately executed, sequentially or in parallel for each of the different feature types. For example, in the context of Fig. 3A, the process can be performed once for all features of the same feature type as feature 302, and can be performed a second time for all features of the same feature type as feature 308.

As another example, if only features of a particular orientation are of interest then they can be grouped, and each orientation group (or only the orientation group of interest) can be separately put through the detection process. For example, in the context of Fig. 3A, the process can be performed for just features of the same vertical orientation as feature 308, and not on features of a different orientation, such as feature 310.

When features are grouped, included, or excluded as described herein, the corresponding 2D projected points can be grouped, included, or excluded accordingly for the detection process.

The examples above serve only as illustrations. Any features that can be processed into a set of 2D points in any way can be handled by techniques disclosed herein, and any such processes are intended to be included as part of receiving the set of 2D points.

The system can then find rectangular, linear, circular, or other patterns within the points.

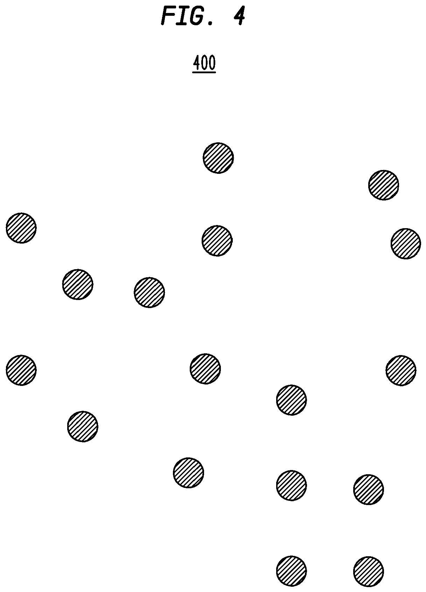

Figure 4 illustrates an example of a set of 2D points 400 corresponding to a geometric model (2D, or 3D via a projection technique such as described above) that can be processed in accordance with disclosed embodiments after being received. The system can detect patterns among the 2D points.

Returning to the process of Fig. 2, the system identifies the nearest "neighbor" points for each point in the set (210). The term "neighbor," as used herein, refers to one or more points closest to one or more points comprising a set of points. The number of nearest neighbors identified for each point can depend on the "indicators" selected, as described below, or can include any number of neighbors. Indicators, such as pattern indicators recognized by the system, include but are not limited to, rectangular pattern indicators, linear pattern indicators, circular pattern indicators, and skew pattern indicators; other pattern indicators are contemplated. The identification process 210 includes determining the distance and direction (together, the vector) from each point to its neighbor points.

The system then finds indicated patterns among the set of points (215). For each point in the set, the system determines whether it and its nearest neighbors indicate any patterns. Note that a single point can indicate multiple pattern types. The system receives a user selection of pattern indicators to apply so that only certain types of patterns are identified or applies any or all pattern indicators.

The pattern indicators indicate a pattern among the points. Each point is checked against its nearest neighbors to see if it indicates a pattern. If it does then the information about this pattern (e.g. type, spacing, directions) can be stored together with an identification of the point that first indicated it (origin), as described below.

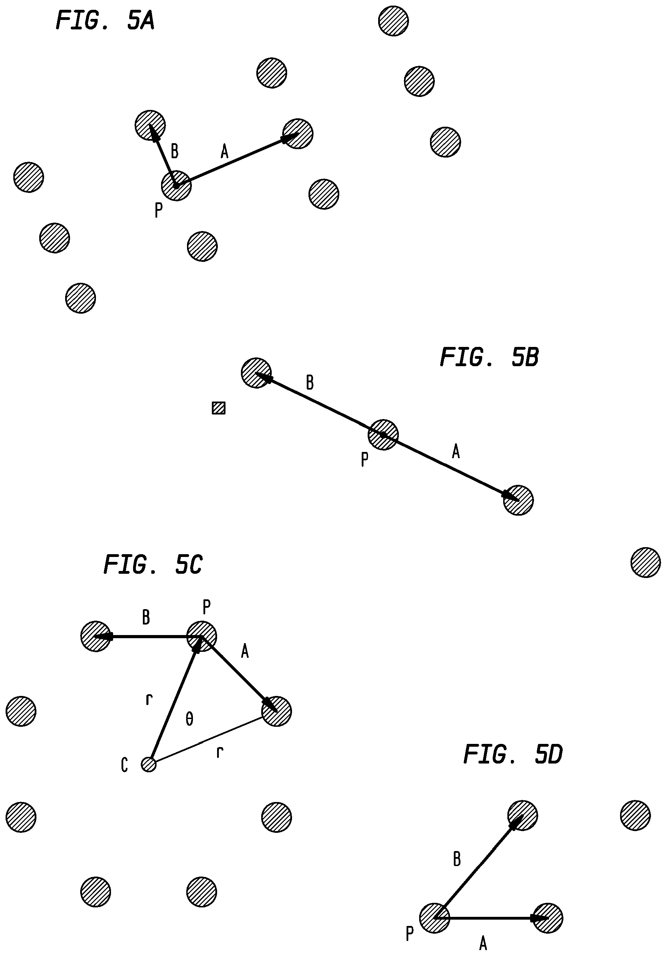

Figures 5A-5D illustrate examples of pattern indicators in accordance with disclosed embodiment. These indicators are not limiting, and other indicators of patterns between points can be used.

Fig. 5A illustrates an example of a rectangular pattern indicator. In this example, point P is the point being processed. The vectors A and B from P to its nearest neighbors are found. Vectors A and B are orthogonal (90 degrees) to each other, and form an example of a rectangular pattern indicator. A rectangular pattern identified by a plurality of points in the set at regular distances from the given point P in orthogonal directions. Note that "regular distances," as used herein, can include multiples of a regular distance without a point at each interval. For example, this is intended to include the case where a first neighboring point is at a distance X, and the next point in the pattern, in the same direction, is at distance 4X, even if there were no points in the set at distances 2X or 3X.

Fig. 5B illustrates an example of a linear pattern indicator. In this example, point P is the point being processed. The vectors A and B from P to its nearest neighbors are found. Vectors A and B are linear (180 degrees, in line) to each other and of equal magnitude, and form an example of a linear pattern indicator. The linear pattern can therefore be identified by a plurality of points in the set at regular distances from and in line with the given point P within a 2D plane.

Fig. 5C illustrates an example of a circular pattern indicator. In this example, point P is the point being processed. The vectors A and B from P to its nearest neighbors are found. Vectors A and B are the same magnitude as each other; that is, the neighbor points to P are of equal distance from P. The system can calculate the center C, radius r, and angle θ between successive pattern elements with respect to the center of an indicated pattern from the points A, B, and P. A circular pattern can therefore be identified by a plurality of points in the set at regular distances from each other and that each lie along an arc of a circle with a common center C (though the circle and its center are not part of the points or the model).

Fig. 5D illustrates an example of a "skew" pattern indicator. Skew patterns are a natural extension of rectangular patterns where the angle between the directions is varied from 90 degrees, so the vectors are not orthogonal to each other. A skew pattern can be identified by a plurality of points in the set at regular distances from and in line with a given point in two directions within the 2D plane. In this example, point P is the point being processed. The vectors A and B from P to its nearest neighbors are found. Vectors A and B are not orthogonal to each other, and form an example of a skew pattern indicator. A skew pattern can be identified by a plurality of points in the set at regular distances from and in line with a given point in two directions within the 2D plane..

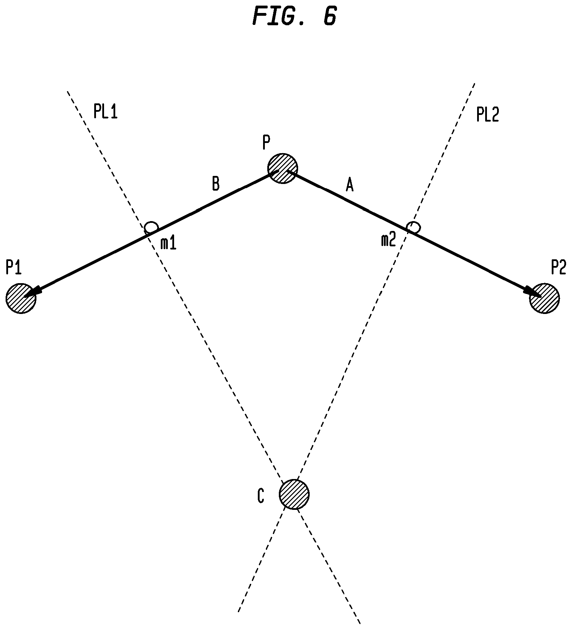

Figure 6 illustrates one technique for calculating the center C for the circular indicator, given point P, vector A from point P to neighboring point P2, and vector B from point P to neighboring point P1. The system can define a line PL1 as the bisector of vector B at midpoint m1, orthogonal to vector B. The system can define a line PL2 as the bisector of vector A at midpoint m2, orthogonal to vector A. The center C of the circle pattern is the intersection of PL1 and PL2.

There are two types of circular patterns indicated by various embodiments - open circular patterns and closed circular patterns. They are both indicated by the same indicator form but importantly the angle θ for closed patterns must be a value that divides 360 degrees (i.e. 360° = N^{∗} angle θ, where N is natural number). That is, the angle between points on a "closed" circular pattern divides evenly into 360 degrees, so that the set of points in the closed circular pattern would be evenly spaced on the circumference of the implied circle if there were enough points to complete the circle. An "open" circular pattern has no such requirement; the angle θ is not evenly divisible into 360 degrees, and though the actual points in the set are evenly spaced on the implied circle, if there were enough points to complete the circle, then at least two of them could not be evenly spaced.

Returning to the process illustrated in Fig. 2, as part of finding indicated patterns at 215, for each type of pattern indicated by a given point (if any), the system can check whether this pattern has already been indicated by comparing indicated patterns. If the pattern has not already been indicated, the system can store the newly-found pattern, such as by adding to a list of indicated patterns the following data and comparing the data to determine that the pattern is already indicated:
- For rectangular patterns, the system can store x and y spacing, and x and y directions. The first point that indicated this pattern can be used as the origin (which is stored as origin for the first point). Rectangular patterns indicate the same pattern as a previous pattern when their respective patterns fall on one another, so x and y spacing is equal, x and y directions parallel respectively (and orthogonal to each other), and the origin of each lies on the pattern of the other.
- For linear patterns, the system can store spacing, direction and origin. The first point that indicated this pattern can be used as the origin (which is stored as origin for the first point). Linear patterns indicate the same pattern as a previous pattern when their respective patterns fall on one another, so the spacing between points is equal, the vector directions are parallel, and the origin of each lies on the pattern of the other.
- For circular patterns, the system can store center, angular spacing, direction, and origin. The first point that indicated this pattern can be used as the origin (which is stored as origin for the first point). Circular patterns indicate the same pattern as a previous pattern when their respective patterns fall on one another, so the angle spacings θ are equal, the centers C are equal, the radii r (center to origin distance) are equal, and the origin of each lies on the pattern of the other. The circular pattern does not require a full "set" of points to complete a circle.

If the current indicated pattern is the same as a previously found indicated pattern, then the system can increment the count of this indicated pattern.

The system can consolidate found linear patterns into rectangular patterns (220). The pattern-finding process can occasionally generate what would ideally be rectangular patterns as individual linear patterns. In such cases, the system can correct this and combine such cases into rectangular patterns.

The system can select a primary pattern (225). From all indicated patterns, at this stage, the system can select a primary pattern. The primary pattern can be selected from the indicated patterns in various ways to meet particular demands. For example, one criterion for selecting the primary pattern can be the pattern containing the largest number of points. In many cases, when selecting a primary pattern, any indicated patterns with three points or less are ignored.

The system stores pattern data including the associated points (230). This includes labelling, and can include marking, or otherwise associating with the patterns, including any primary pattern, all the points from the set that match the primary pattern, and with any 2D or 3D features that were used to produce the set of points, and storing this pattern data. This can include removing all points that correspond to the primary pattern, or from all found patterns, from the set of points. In various embodiments, all points that correspond to found patterns can be removed, or only points that correspond to the primary pattern can be removed. All of the points that match the patterns, in either of these cases, can be removed from the set of points currently being processed, so that additional patterns can be found that do not include the points already associated with the primary pattern or other found patterns.

The system can repeat the process to 210, now processing only the remaining points in the set, to find another other patterns. That is, once the points in the first primary pattern or all found patterns are removed from the set, the system can repeat the process using only the remaining points, beginning with finding the nearest neighbors to each remaining point.

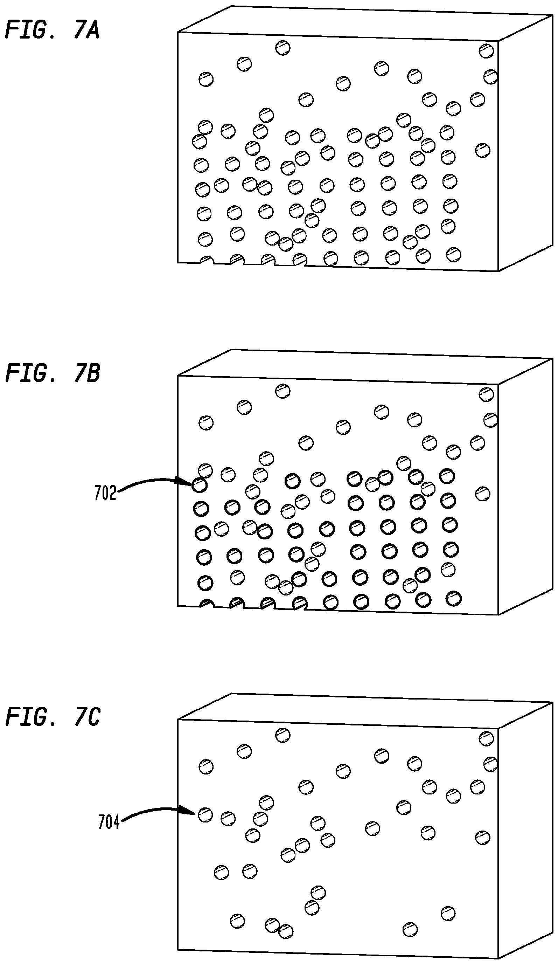

Figures 7A-7J illustrate an example of the results and some advantages of an iterative process as described herein; other advantages exist. Figure 7A illustrates an example of an input set of points for the first iteration of a process as described herein.

Figure 7B illustrates an example of a rectangular pattern identified in the first iteration of a process as described herein, such as illustrated at 702.

After these patterns have been identified in the first iteration, all the points in these patterns are removed from the original set of points, and the remaining points are processed in a second iteration.

Figure 7C illustrates an example of the remaining set of points after the rectangular pattern identified in the first iteration (as illustrated in Fig. 7B) are removed from the input set of points after the first iteration. These remaining points 704 are input to the second iteration. Note that, for illustrative purposes, the features or points for the pattern are actually removed from the illustrated model; in a typical implementation, however, these features or points only removed from consideration in the data, and are not included in the set of points passed to the next iteration of the process.

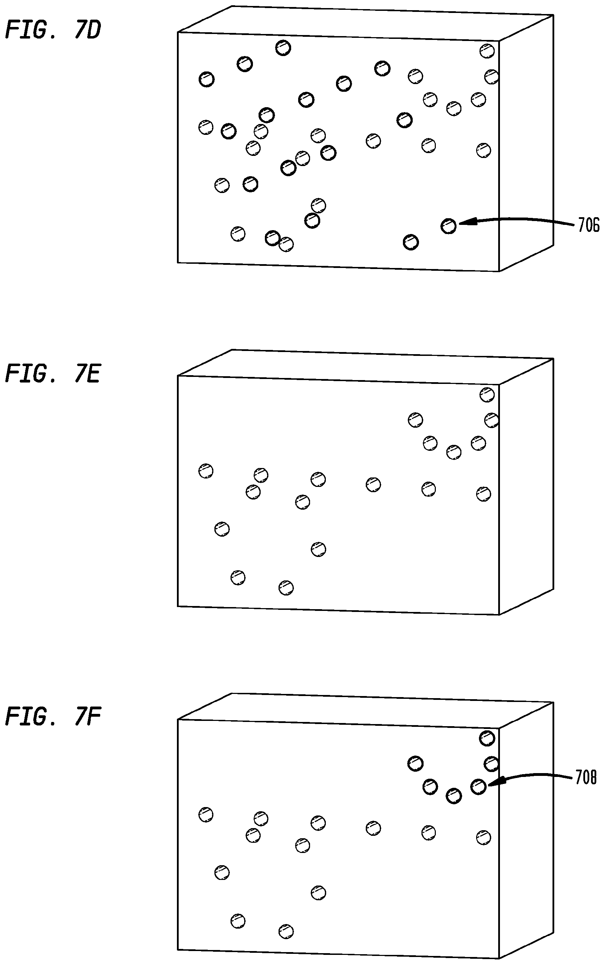

Figure 7D illustrates an example of a rectangular pattern identified in the second iteration of a process as described herein, such as illustrated at 706. Note that this pattern may not have been identified in the first iteration because the now-removed points obscured the pattern when processed as neighboring points.

Figure 7E illustrates an example of the remaining set of points after the rectangular pattern identified in the second iteration (as illustrated in Fig. 7D) are also removed from the set of points being processed. These remaining points are input to the third iteration.

Figure 7F illustrates an example of a circular pattern identified in the third iteration of a process as described herein, such as illustrated at 708. Note that this pattern may not have been identified in the first iteration because the now-removed points obscured the pattern when processed as neighboring points.

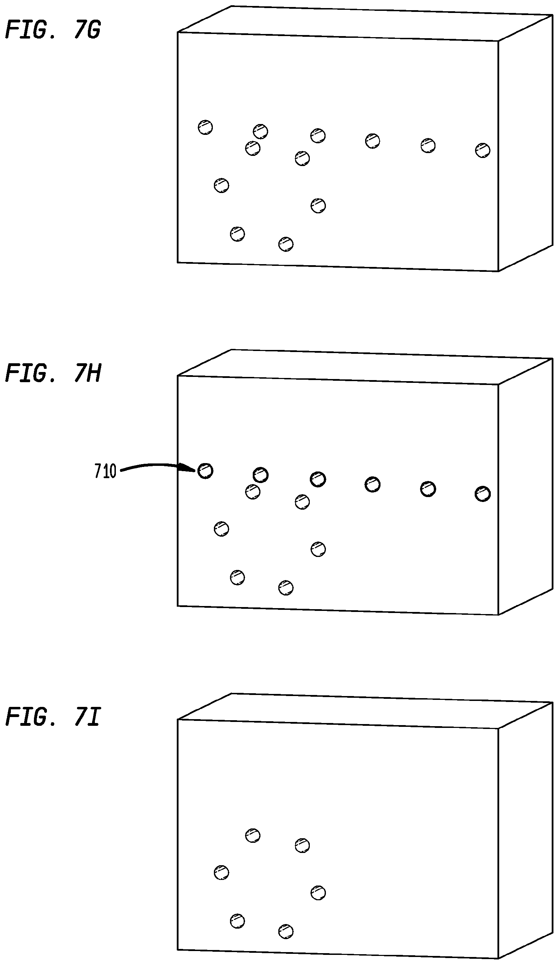

Figure 7G illustrates an example of the remaining set of points after the circular pattern identified in the third iteration (as illustrated in Fig. 7F) are also removed from the set of points being processed. These remaining points are input to the fourth iteration.

Figure 7H illustrates an example of a linear pattern identified in the fourth iteration of a process as described herein, such as illustrated at 710. Note that this pattern may not have been identified in the first iteration because the now-removed points obscured the pattern when processed as neighboring points.

Figure 7I illustrates an example of the remaining set of points after the linear pattern identified in the fourth iteration (as illustrated in Fig. 7H) are also removed from the set of points being processed. These remaining points are input to the fifth iteration.

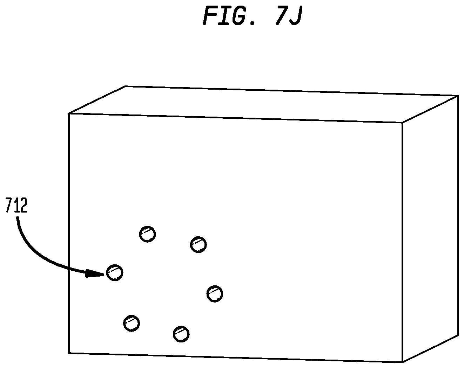

Figure 7J illustrates an example of a circular pattern identified in the fifth iteration of a process as described herein, such as illustrated at 712. Note that this pattern may not have been identified in the first iteration because the now-removed points obscured the pattern when processed as neighboring points.

Other embodiments include variations on the specific techniques disclosed above. For example, a "linear" pattern could alternatively be represented as a rectangular pattern with Y count equal to one and y-spacing equal to zero. In some embodiments, all the points can be stored in a tree structure, which makes finding the closest neighbors much faster.

In some embodiments, to prevent finding of all the possible linear patterns within rectangular patterns, the system can first find rectangular and circular patterns, remove them from the input set of points, and then search for linear pattern in remaining data in a subsequent iteration.

Of course, those of skill in the art will recognize that, unless specifically indicated or required by the sequence of operations, certain steps in the processes described above may be omitted, performed concurrently or sequentially, or performed in a different order.

Those skilled in the art will recognize that, for simplicity and clarity, the full structure and operation of all data processing systems suitable for use with the present disclosure is not being depicted or described herein. Instead, only so much of a data processing system as is unique to the present disclosure or necessary for an understanding of the present disclosure is depicted and described. The remainder of the construction and operation of data processing system 100 may conform to any of the various current implementations and practices known in the art.

It is important to note that while the disclosure includes a description in the context of a fully functional system, those skilled in the art will appreciate that at least portions of the mechanism of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

## Claims

1. A method for pattern recognition in CAD models containing implicit patterns which are not explicitly labelled, the method performed by a data processing system (100) and comprising:
receiving (205) a set of two-dimensional (2D) points (400) representing 2 dimensional or 3 dimensional features of a geometric model by the data processing system;
identifying (210) nearest neighbor points for each of a plurality of points in the set, by the data processing system, wherein the identification process comprises the data processing system determining a distance and direction, together a vector, between each point P in the set and each nearest neighbor point to the point in the set;
finding (215) at least one indicated pattern between points in the set by determining, for each point P in the set, whether it and two of its nearest neighbors indicate any patterns, wherein pattern indicators indicate a pattern among the points, wherein the system receives a user selection of pattern indicators to apply so that only certain types of patterns are identified or applies any or all pattern indicators, and each point P is checked against its two nearest neighbors to see if it indicates a pattern, the pattern comprising a structured organization of features of the geometric model with respect to each other, by the data processing system;
wherein the indicated pattern is one of
a linear pattern (710) identified by a plurality of points in the set at regular distances from and in line with a given point (P) within a 2D plane, wherein two vectors A, B between the point P and its two nearest neighbors are linear,
a rectangular pattern (702) identified by a plurality of points in the set at regular distances from a given point (P) in orthogonal directions, wherein two vectors A, B between the point P and its two nearest neighbors are orthogonal to each other,
a skew pattern identified by a plurality of points in the set at regular distances from and in line with a given point (P) in two directions within the 2D plane, wherein two vectors A, B between the point P and its two nearest neighbors are not orthogonal to each other, or
a circular pattern (708, 712) identified by a plurality of points in the set at regular distances from each other and that each lie along an arc of a circle with a common center (C), wherein vector A from point P to neighboring point P2, and vector B from point P to neighboring point P1 defines a line PL1 as the bisector of vector B at midpoint m1, orthogonal to vector B, and a line PL2 is defined as the bisector of vector A at midpoint m2, orthogonal to vector A, wherein the center Cof the circle pattern is the intersection of PL1 and PL2;
wherein the regular distances are all the same distance, or include multiples of the distance; and
storing (230) pattern data including the pattern data corresponding to the found indicated pattern by labelling all of the points from the set that match the found indicated pattern.

2. The method of claim 1, wherein the data processing system also converts 2D or three-dimensional features (320) into the set of 2D points.

3. The method of claim 1 or 2, wherein the data processing system consolidates (220) multiple linear patterns into a rectangular pattern.

4. The method of any of claims 1 to 3, wherein points corresponding to the found indicated pattern are removed from the set of 2D points, and the data processing system repeats identifying, finding, and storing.

5. The method of any of claims 1 to 4, wherein the data processing system finds multiple indicated patterns, and selects (225) a primary pattern from the multiple found indicated patterns.

6. A data processing system (100) for CAD models containing implicit patterns which are not explicitly labelled comprising: a processor (102); and an accessible memory (108), the data processing system particularly configured to receive (205) a set of two-dimensional - 2D - points (400) representing 2 dimensional or 3 dimensional features of a geometric model; identify (210) nearest neighbor points for each of a plurality of points (400) in the set wherein the identification process comprises the data processing system determines a distance and direction, together a vector, between each point P in the set and each nearest neighbor point to the point in the set; find (215) at least one indicated pattern between points in the set by determining, for each point P in the set, whether it and two of its nearest neighbors indicate any patterns, wherein pattern indicators indicate a pattern among the points, wherein the system receives a user selection of pattern indicators to apply so that only certain types of patterns are identified or applies any or all pattern indicators and each point P is checked against its two nearest neighbors to see if it indicates a pattern, the pattern comprising a structured organization of features of the geometric model with respect to each other, wherein the indicated pattern is one of a linear pattern (710) identified by a plurality of points in the set at regular distances from and in line with a given point (P) within a 2D plane wherein two vectors A, B between the point P and its two nearest neighbors are linear, a rectangular pattern (702) identified by a plurality of points in the set at regular distances from a given point (P) in orthogonal directions wherein two vectors A, B between the point P and its two nearest neighbors are orthogonal to each other, a skew pattern identified by a plurality of points in the set at regular distances from and in line with a given point (P) in two directions within the 2D plane wherein two vectors A, B between the point P and its two nearest neighbors are not orthogonal to each other, or a circular pattern (708, 712) identified by a plurality of points in the set at regular distances from each other and that each lie along an arc of a circle with a common center (C) wherein vector A from point P to neighboring point P2, and vector B from point P to neighboring point P1 defines a line PL1 as the bisector of vector B at midpoint m1, orthogonal to vector B, and a line PL2 is defined as the bisector of vector A at midpoint m2, orthogonal to vector A, wherein the center Cof the circle pattern is the intersection of PL1 and PL2; wherein the regular distances are all the same distance, or include multiples of the distance; and store (230) pattern data including the pattern data corresponding to the found indicated pattern by labelling all of the points from the set that match the found indicated pattern.

7. The data processing system of claim 6, wherein the data processing system also converts 2D or three-dimensional features (320) into the set of 2D points.

8. The data processing system of claim 6 or 7, wherein the data processing system consolidates (220) multiple linear patterns into a rectangular pattern.

9. The data processing system (100) of any of claims 6 to 8, wherein points corresponding to the found indicated pattern are removed from the set of 2D points, and the data processing system repeats identifying, finding, and storing.

10. The data processing system (100) of any of claims 6 to 9, wherein the data processing system finds multiple indicated patterns, and selects (225) a primary pattern from the multiple found indicated patterns.

11. A non-transitory computer-readable medium (126) encoded with executable instructions that, when executed, cause one or more data processing systems (100) to perform a method according to any of claims 1 to 5.

## Patentansprüche

1. Verfahren für die Mustererkennung in CAD-Modellen, die implizite Muster enthalten, welche nicht ausdrücklich benannt sind, wobei das Verfahren von einem Datenverarbeitungssystem (100) durchgeführt wird und Folgendes umfasst:
Empfangen (205) eines Satzes zweidimensionaler (2D-) Punkte (400), der 2- oder 3-dimensionale Merkmale eines geometrischen Modells repräsentiert, durch das Datenverarbeitungssystem,
Identifizieren (210) von nächstgelegenen Nachbarpunkten für jeden von mehreren Punkten in dem Satz durch das Datenverarbeitungssystem, wobei der Identifizierungsprozess umfasst, dass das Datenverarbeitungssystem eine Entfernung und
eine Richtung, die zusammen einen Vektor ergeben, zwischen jedem Punkt P in dem Satz und jedem nächstgelegenen Nachbarpunkt zu dem Punkt in dem Satz bestimmt,
Finden (215) mindestens eines erkennbaren Musters zwischen Punkten in dem Satz durch Bestimmen für jeden Punkt P in dem Satz, ob er und zwei seiner nächstgelegenen Nachbarn ein Muster erkennbar machen, wobei Musterindikatoren ein Muster unter den Punkten erkennbar machen, wobei das System eine Benutzerauswahl an anzuwendenden Musterindikatoren empfängt,
so dass nur bestimmte Typen von Mustern identifiziert werden,
oder beliebige oder alle Musterindikatoren anwendet und jeder Punkt P von dem Datenverarbeitungssystem mit seinen zwei nächstgelegenen Nachbarn verglichen wird, um herauszufinden,
ob er ein Muster erkennbar macht, wobei das Muster eine strukturierte Ordnung von Merkmalen des geometrischen Modells in Bezug zueinander umfasst,
wobei es sich bei dem erkennbaren Muster um eines der folgenden handelt:
ein lineares Muster (710), das durch mehrere Punkte in dem Satz identifiziert wird, die in einer 2D-Ebene in regelmäßigen Abständen zu einem gegebenen Punkt (P) und damit in einer Linie liegen, wobei zwei Vektoren A, B zwischen dem Punkt P und seinen zwei nächstgelegenen Nachbarn linear sind,
ein rechteckiges Muster (702), das durch mehrere Punkte in dem Satz identifiziert wird, die in orthogonalen Richtungen in regelmäßigen Abständen zu einem gegebenen Punkt (P) liegen,
wobei zwei Vektoren A, B zwischen dem Punkt P und seinen zwei nächstgelegenen Nachbarn orthogonal zueinander sind,
ein schräges Muster, das durch mehrere Punkte in dem Satz identifiziert wird, die in zwei Richtungen in der 2D-Ebene in regelmäßigen Abständen zu einem gegebenen Punkt (P) und damit in einer Linie liegen, wobei zwei Vektoren A, B zwischen dem Punkt P und seinen zwei nächstgelegenen Nachbarn nicht orthogonal zueinander sind, oder
ein kreisförmiges Muster (708, 712), das durch mehrere Punkte in dem Satz identifiziert wird, die in regelmäßigen Abständen zueinander und auf einem Kreisbogen mit einem gemeinsamen Mittelpunkt (C) liegen, wobei ein Vektor A vom Punkt P zum benachbarten Punkt P2 und ein Vektor B vom Punkt P zum benachbarten Punkt P1 eine Linie PL1 als senkrecht zum Vektor B verlaufende Halbierende von Vektor B am Mittelpunkt m1 definiert und eine Linie PL2 als senkrecht zum Vektor A verlaufende Halbierende von Vektor A am Mittelpunkt m2 definiert ist, wobei es sich bei dem Mittelpunkt C des Kreismusters um den Schnittpunkt von PL1 und PL2 handelt,
wobei es sich bei den regelmäßigen Abständen um den gleichen Abstand oder um ein Mehrfaches des Abstands handelt,
und
Speichern (230) von Musterdaten einschließlich der Musterdaten, die dem gefundenen erkennbaren Muster entsprechen, durch Benennen aller Punkte aus dem Satz, die mit dem gefundenen erkennbaren Muster übereinstimmen.

2. Verfahren nach Anspruch 1, wobei das Datenverarbeitungssystem auch 2D- oder dreidimensionale Merkmale (320) in den Satz 2D-Punkte umwandelt.

3. Verfahren nach Anspruch 1 oder 2, wobei das Datenverarbeitungssystem mehrere lineare Muster zu einem rechteckigen Muster zusammenfügt (220).

4. Verfahren nach einem der Ansprüche 1 bis 3, wobei dem gefundenen erkennbaren Muster entsprechende Punkte aus dem Satz 2D-Punkte entfernt werden und das Datenverarbeitungssystem das Identifizieren, Finden und Speichern wiederholt.

5. Verfahren nach einem der Ansprüche 1 bis 4, wobei das Datenverarbeitungssystem mehrere erkennbare Muster findet und unter den mehreren gefundenen erkennbaren Mustern ein primäres Muster auswählt (225).

6. Datenverarbeitungssystem (100) für CAD-Modelle, die implizite Muster enthalten, welche nicht ausdrücklich benannt sind, mit Folgendem: einem Prozessor (102) und einem verfügbaren Speicher (108), wobei das Datenverarbeitungssystem insbesondere so konfiguriert ist, dass es einen Satz zweidimensionale (2D-) Punkte (400) empfängt (205), der 2- oder 3-dimensionale Merkmale eines geometrischen Modells repräsentiert, nächstgelegene Nachbarpunkte für jeden von mehreren Punkten (400) in dem Satz identifiziert (210), wobei der Identifizierungsprozess umfasst, dass das Datenverarbeitungssystem eine Entfernung und eine Richtung, die zusammen einen Vektor ergeben, zwischen jedem Punkt P in dem Satz und jedem nächstgelegenen Nachbarpunkt zu dem Punkt in dem Satz bestimmt, mindestens ein erkennbares Muster zwischen Punkten in dem Satz findet (215), indem es für jeden Punkt P in dem Satz bestimmt, ob er und zwei seiner nächstgelegenen Nachbarn ein Muster erkennbar machen, wobei Musterindikatoren ein Muster unter den Punkten erkennbar machen, wobei das System eine Benutzerauswahl an anzuwendenden Musterindikatoren empfängt, so dass nur bestimmte Typen von Mustern identifiziert werden, oder beliebige oder alle Musterindikatoren anwendet und jeder Punkt P mit seinen zwei nächstgelegenen Nachbarn verglichen wird, um herauszufinden, ob er ein Muster erkennbar macht, wobei das Muster eine strukturierte Ordnung von Merkmalen des geometrischen Modells in Bezug zueinander umfasst, wobei es sich bei dem erkennbaren Muster um eines der folgenden handelt: ein lineares Muster (710), das durch mehrere Punkte in dem Satz identifiziert wird, die in regelmäßigen Abständen zu einem gegebenen Punkt (P) in einer 2D-Ebene und damit in einer Linie liegen, wobei zwei Vektoren A, B zwischen dem Punkt P und seinen zwei nächstgelegenen Nachbarn linear sind, ein rechteckiges Muster (702), das durch mehrere Punkte in dem Satz identifiziert wird, die in orthogonalen Richtungen in regelmäßigen Abständen zu einem gegebenen Punkt (P) liegen, wobei zwei Vektoren A, B zwischen dem Punkt P und seinen zwei nächstgelegenen Nachbarn orthogonal zueinander sind, ein schräges Muster, das durch mehrere Punkte in dem Satz identifiziert wird, die in zwei Richtungen in der 2D-Ebene in regelmäßigen Abständen zu einem gegebenen Punkt (P) und damit in einer Linie liegen, wobei zwei Vektoren A, B zwischen dem Punkt P und seinen zwei nächstgelegenen Nachbarn nicht orthogonal zueinander sind, oder ein kreisförmiges Muster (708, 712), das durch mehrere Punkte in dem Satz identifiziert wird, die in regelmäßigen Abständen zueinander und auf einem Kreisbogen mit einem gemeinsamen Mittelpunkt (C) liegen, wobei ein Vektor A vom Punkt P zum benachbarten Punkt P2 und ein Vektor B vom Punkt P zum benachbarten Punkt P1 eine Linie PL1 als senkrecht zum Vektor B verlaufende Halbierende von Vektor B am Mittelpunkt m1 definiert und eine Linie PL2 als senkrecht zum Vektor A verlaufende Halbierende von Vektor A am Mittelpunkt m2 definiert ist, wobei es sich bei dem Mittelpunkt C des Kreismusters um den Schnittpunkt von PL1 und PL2 handelt, wobei es sich bei den regelmäßigen Abständen um den gleichen Abstand oder um ein Mehrfaches des Abstands handelt, und Musterdaten einschließlich der Musterdaten, die dem gefundenen erkennbaren Muster entsprechen, durch Benennen aller Punkte aus dem Satz, die mit dem gefundenen erkennbaren Muster übereinstimmen, speichert (230).

7. Datenverarbeitungssystem nach Anspruch 6, wobei das Datenverarbeitungssystem auch 2D- oder dreidimensionale Merkmale (320) in den Satz 2D-Punkte umwandelt.

8. Datenverarbeitungssystem nach Anspruch 6 oder 7, wobei das Datenverarbeitungssystem mehrere lineare Muster zu einem rechteckigen Muster zusammenfügt (220).

9. Datenverarbeitungssystem (100) nach einem der Ansprüche 6 bis 8, wobei dem gefundenen erkennbaren Muster entsprechende Punkte aus dem Satz 2D-Punkte entfernt werden und das Datenverarbeitungssystem das Identifizieren, Finden und Speichern wiederholt.

10. Datenverarbeitungssystem (100) nach einem der Ansprüche 6 bis 9, wobei das Datenverarbeitungssystem mehrere erkennbare Muster findet und unter den mehreren gefundenen erkennbaren Mustern ein primäres Muster auswählt (225).

11. Nichtflüchtiges, computerlesbares Medium (126), das mit ausführbaren Anweisungen codiert ist, die, wenn sie ausgeführt werden, ein oder mehrere Datenverarbeitungssysteme (100) dazu veranlassen, ein Verfahren nach einem der Ansprüche 1 bis 5 durchzuführen.

## Revendications

1. Procédé de reconnaissance de motif dans des modèles CAO contenant des motifs implicites qui ne sont pas explicitement étiquetés, le procédé étant effectué par un système de traitement de données (100) et comprenant les étapes consistant à :
recevoir (205) un ensemble de points bidimensionnels (2D) (400) représentant des caractéristiques bidimensionnelles ou tridimensionnelles d'un modèle géométrique par le système de traitement de données ;
identifier (210) des points voisins les plus proches pour chacun d'une pluralité de points dans l'ensemble, par le système de traitement de données, dans lequel le processus d'identification comprend le système de traitement de données déterminant une distance et une direction, avec un vecteur, entre chaque point P dans l'ensemble et chaque point voisin le plus proche jusqu'au point dans l'ensemble ;
trouver (215) au moins un motif indiqué entre des points dans l'ensemble en déterminant, pour chaque point P dans l'ensemble, si celui-ci et deux de ses voisins les plus proches indiquent des motifs, dans lequel
des indicateurs de motif indiquent un motif parmi les points, dans lequel le système reçoit une sélection utilisateur d'indicateurs de motif à appliquer de sorte que seuls certains types de motifs soient identifiés ou applique tout ou partie des indicateurs de motif, et chaque point P est vérifié par rapport à ses deux voisins les plus proches pour voir s'il indique un motif, le motif comprenant une organisation structurée de caractéristiques du modèle géométrique les unes par rapport aux autres, par le système de traitement de données ;
dans lequel le motif indiqué est l'un parmi un motif linéaire (710) identifié par une pluralité de points dans l'ensemble à des distances régulières d'un point donné (P) dans un plan 2D et aligné avec celui-ci, dans lequel deux vecteurs A, B entre le point P et ses deux voisins les plus proches sont linéaires,
un motif rectangulaire (702) identifié par une pluralité de points dans l'ensemble à des distances régulières d'un point donné (P) dans des directions orthogonales, dans lequel deux vecteurs A, B entre le point P et ses deux voisins les plus proches sont orthogonaux l'un par rapport à l'autre,
un motif de biais identifié par une pluralité de points dans l'ensemble à des distances régulières à partir d'un point donné (P) dans deux directions dans le plan 2D et aligné avec celui-ci, dans lequel deux vecteurs A, B entre le point P et ses deux voisins les plus proches ne sont pas orthogonaux l'un par rapport à l'autre, ou
un motif circulaire (708, 712) identifié par une pluralité de points dans l'ensemble à des distances régulières les uns des autres et que chacun se trouve le long d'un arc de cercle avec un centre commun (C), dans lequel le vecteur A du point P au point voisin P2, et le vecteur B du point P au point voisin P1 définissent une ligne PL1 comme la bissectrice du vecteur B au point médian m1, orthogonale au vecteur B, et une ligne PL2 est définie comme la bissectrice du vecteur A au point médian m2, orthogonale au vecteur A, dans lequel le centre C du motif circulaire est l'intersection de PL1 et PL2 ;
dans lequel les distances régulières sont toutes les mêmes distances, ou incluent des multiples de la distance ;
et
stocker (230) des données de motif incluant les données de motif correspondant au motif indiqué trouvé en étiquetant tous les points de l'ensemble qui correspondent au motif indiqué trouvé.

2. Procédé selon la revendication 1, dans lequel le système de traitement de données convertit également des caractéristiques 2D ou tridimensionnelles (320) en l'ensemble de points 2D.

3. Procédé selon la revendication 1 ou 2, dans lequel le système de traitement de données consolide (220) de multiples motifs linéaires en un motif rectangulaire.

4. Procédé selon l'une quelconque des revendications 1 à 3, dans lequel des points correspondant au motif indiqué trouvé sont supprimés de l'ensemble de points 2D, et le système de traitement de données répète l'identification, la recherche et le stockage.

5. Procédé selon l'une quelconque des revendications 1 à 4, dans lequel le système de traitement de données trouve de multiples motifs indiqués, et sélectionne (225) un motif primaire à partir des multiples motifs indiqués trouvés.

6. Système de traitement de données (100) pour des modèles CAO contenant des motifs implicites qui ne sont pas explicitement étiquetés comprenant : un processeur (102) ; et une mémoire accessible (108), le système de traitement de données étant spécialement configuré pour recevoir (205) un ensemble de points bidimensionnels, 2D, (400) représentant des caractéristiques bidimensionnelles ou tridimensionnelles d'un modèle géométrique ; identifier (210) des points voisins les plus proches pour chacun d'une pluralité de points (400) dans l'ensemble dans lequel le processus d'identification comprend le système de traitement de données déterminant une distance et une direction, avec un vecteur, entre chaque point P dans l'ensemble et chaque point voisin le plus proche du point dans l'ensemble ; trouver (215) au moins un motif indiqué entre des points dans l'ensemble en déterminant, pour chaque point P dans l'ensemble, si celui-ci et deux de ses voisins les plus proches indiquent des motifs, dans lequel des indicateurs de motif indiquent un motif parmi les points, dans lequel le système reçoit une sélection utilisateur d'indicateurs de motif à appliquer de sorte que seuls certains types de motifs soient identifiés ou applique tout ou partie des indicateurs de motif et chaque point P est vérifié par rapport à ses deux voisins les plus proches pour voir s'il indique un motif, le motif comprenant une organisation structurée de caractéristiques du modèle géométrique les unes par rapport aux autres, dans lequel le motif indiqué est l'un parmi un motif linéaire (710) identifié par une pluralité de points dans l'ensemble à des distances régulières d'un point donné (P) dans un plan 2D et aligné avec celui-ci, dans lequel deux vecteurs A, B entre le point P et ses deux voisins les plus proches sont linéaires, un motif rectangulaire (702) identifié par une pluralité de points dans l'ensemble à des distances régulières d'un point donné (P) dans des directions orthogonales, dans lequel deux vecteurs A, B entre le point P et ses deux voisins les plus proches sont orthogonaux l'un par rapport à l'autre, un motif de biais identifié par une pluralité de points dans l'ensemble à des distances régulières à partir d'un point donné (P) dans deux directions dans le plan 2D et aligné avec celui-ci, dans lequel deux vecteurs A, B entre le point P et ses deux voisins les plus proches ne sont pas orthogonaux l'un par rapport à l'autre, ou un motif circulaire (708, 712) identifié par une pluralité de points dans l'ensemble à des distances régulières les uns des autres et que chacun se trouve le long d'un arc de cercle avec un centre commun (C), dans lequel le vecteur A du point P au point voisin P2, et le vecteur B du point P au point voisin P1 définissent une ligne PL1 comme la bissectrice du vecteur B au point médian m1, orthogonale au vecteur B, et une ligne PL2 est définie comme la bissectrice du vecteur A au point médian m2, orthogonale au vecteur A, dans lequel le centre C du motif circulaire est l'intersection de PL1 et PL2 ; dans lequel les distances régulières sont toutes les mêmes distances, ou incluent des multiples de la distance ; et stocker (230) des données de motif incluant les données de motif correspondant au motif indiqué trouvé en étiquetant tous les points de l'ensemble qui correspondent au motif indiqué trouvé.

7. Système de traitement de données selon la revendication 6, dans lequel le système de traitement de données convertit également des caractéristiques 2D ou tridimensionnelles (320) en l'ensemble de points 2D.

8. Système de traitement de données selon la revendication 6 ou 7, dans lequel le système de traitement de données consolide (220) de multiples motifs linéaires en un motif rectangulaire.

9. Système de traitement de données (100) selon l'une quelconque des revendications 6 à 8, dans lequel des points correspondant au motif indiqué trouvé sont supprimés de l'ensemble de points 2D, et le système de traitement de données répète l'identification, la recherche et le stockage.

10. Système de traitement de données (100) selon l'une quelconque des revendications 6 à 9, dans lequel le système de traitement de données trouve de multiples motifs indiqués, et sélectionne (225) un motif primaire à partir des multiples motifs indiqués trouvés.

11. Support non transitoire lisible par ordinateur (126) codé avec des instructions exécutables qui, lorsqu'elles sont exécutées, amènent un ou plusieurs systèmes de traitement de données (100) à effectuer un procédé selon l'une quelconque des revendications 1 à 5.
